(19) Europäisches Patentamt
European Patent Office
Office européen des brevets

(11) **EP 3 583 670 B1**

(12) **EUROPÄISCHE PATENTSCHRIFT**

(45) Veröffentlichungstag und Bekanntmachung des Hinweises auf die Patenterteilung:
**01.12.2021 Patentblatt 2021/48**

(21) Anmeldenummer: **18703942.5**

(22) Anmeldetag: **01.02.2018**

(51) Int Cl.:
*H02H 3/087* (2006.01)  *H02H 3/20* (2006.01)
*H02H 3/38* (2006.01)  *H02H 9/04* (2006.01)

(86) Internationale Anmeldenummer:
**PCT/EP2018/052456**

(87) Internationale Veröffentlichungsnummer:
**WO 2018/149649 (23.08.2018 Gazette 2018/34)**

(54) **ELEKTRONISCHE SICHERUNG FÜR EINE, AN EIN NIEDERVOLT-GLEICHSPANNUNGSNETZ ANSCHLIESSBARE LAST**

ELECTRONIC CIRCUIT-BREAKER FOR A LOAD THAT CAN BE CONNECTED TO A LOW VOLTAGE DC-VOLTAGE NETWORK

FUSIBLE ÉLECTRONIQUE POUR UNE CHARGE POUVANT ÊTRE CONNECTÉE À UN RÉSEAU À BASSE TENSION CONTINUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.02.2017 DE 102017103221**
**02.05.2017 DE 102017109378**

(43) Veröffentlichungstag der Anmeldung:
**25.12.2019 Patentblatt 2019/52**

(73) Patentinhaber: **DEHN SE + Co KG**
**92318 Neumarkt / Opf. (DE)**

(72) Erfinder:
• **BÖHM, Thomas**
**92366 Hohenfels (DE)**
• **SCHORK, Franz**
**90461 Nürnberg (DE)**

(74) Vertreter: **Isarpatent**
**Patent- und Rechtsanwälte Barth**
**Charles Hassa Peckmann & Partner mbB**
**Friedrichstrasse 31**
**80801 München (DE)**

(56) Entgegenhaltungen:
EP-A1- 0 686 953  EP-A1- 3 104 483
WO-A1-2017/021013  DE-A1- 10 358 694
DE-A1-102011 016 140  US-A- 5 440 441
US-A1- 2016 149 403  US-B2- 9 401 593

**Beschreibung**

Die Erfindung betrifft eine elektronische Sicherung für eine, an ein Niedervolt-Gleichspannungsnetz anschließbare Last, bestehend aus zwischen Eingangsklemmen und der Last angeordneten Baugruppen, diese umfassend eine Spannungsüberwachungseinheit, eine Stromüberwachungseinheit sowie Halbleiterschalteinheiten und diesen zugeordnete Steuerungen gemäß Patentanspruch 1.

Elektronische Sicherungen gehören in verschiedenen Ausführungsformen zum Stand der Technik. Typische Arbeitsbereiche dieser Sicherungen liegen im Bereich bis 200 A bei Spannungsklassen zwischen 12 V und 100 V Gleichspannung.

Zum Schutz von Gleichspannungsnetzen und an Gleichspannungsnetzen angeschlossenen Verbrauchern sind darüber hinaus Überspannungsschutzeinrichtungen auf der Basis von Varistoren, Gasableitern, Funkenstrecken oder dergleichen bekannt. Werden Überspannungsschutzeinrichtungen der bekannten Art und elektronische Sicherungen nicht koordiniert eingesetzt, entstehen nicht beherrschbare Probleme, die zu einem ungewollten Auslösen der Sicherung bzw. einem unbeabsichtigten Ansprechen der Überspannungsschutzgeräte und damit unzulässig langen Ausfallzeiten führen. Insbesondere für industrielle Applikationen sind derartige Ausfallzeiten zu vermeiden. Ebenso gilt es, ein bisher übliches händisches Wiederinbetriebnehmen von Schutzeinrichtungen auszuschließen.

Die US 5 875 087 A zeigt diesbezüglich eine Schutzeinrichtung mit integrierter Steuerung zum Schutz von elektrischen Systemen, wobei dort eine Kombination aus Überspannungs- und Überstromschutz für Wechselstromnetze mit automatischem Rücksetzen offenbart ist. Gemäß der US 5 875 087 A wird zur Erfassung von Überströmen ein Stromsensor eingesetzt, welcher eine digitale Steuereinheit mit relevanten Stromdaten versorgt. Die Steuereinheit wertet diese Daten aus und treibt eine mechanische Schalteinrichtung oder einen thermisch aktivierbaren Schalter an. Der Einsatz mechanischer oder thermischer Schalteinrichtungen führt jedoch wiederum zu unvertretbar langen Reaktionszeiten.

Aus der DE 10 2015 105 426 A1 ist eine Sicherheitsvorrichtung für einen wiederaufladbaren elektrischen Energiespeicher vorbekannt. Diesbezüglich soll eine schnelle Unterbindung oder Unterbrechung eines elektrischen Stromflusses ermöglicht werden, wenn abnormale Parameter vorliegen. Dabei soll gleichzeitig der Energieverbrauch für die Sicherheitsvorrichtung reduziert werden. Nach der dortigen Lehre kommen mehrere Halbleiterschalteinheiten zur primären reversiblen Unterbindung des Stromflusses in Abhängigkeit von der Überwachung des Stromflusses und/oder der Spannung zum Einsatz. Für eine irreversible Unterbindung des Stromflusses ist eine pyrotechnisch auslösbare Schalteinheit vorhanden. Unabhängig von dem technischen Aufwand und der Auslösezeit einer solchen pyrotechnisch betreibbaren Schalteinheit ist ein erneutes Verbinden der Last mit der Stromversorgung bzw. dem Netz nicht oder nur mit großem Aufwand möglich.

Andere Sicherheitsschaltungen sind aus den folgenden Dokumenten bekannt: US9401593B2, US5440441A, DE102011016140, EP3104483A1, US2016/149403, EP0686953A1, DE10358694A1 und WO2017/021013A1.

Mit den bisher bekannten elektronischen Sicherungen ist es nicht möglich, angeschlossene Verbraucher gegen transiente Überspannungen mit Impulsformen von 8/20 $\mu$s bzw. 10/350 $\mu$s und gleichzeitig gegen auftretende Kurzschlussströme zu schützen. Diesbezüglich wären Reaktionszeiten im Nanosekundenbereich notwendig. Ebenso muss die Möglichkeit bestehen, geringe Ansprechspannungen zu realisieren.

Aus dem Vorgenannten ist es daher Aufgabe der Erfindung, eine weiterentwickelte elektronische Sicherung für eine, an ein Niedervolt-Gleichspannungsnetz anschließbare Last anzugeben, welche auf mechanische Schaltelemente oder Schalteinrichtungen vollständig verzichtet und die in der Lage ist, Reaktionszeiten im Nanosekundenbereich zu gewährleisten. Dabei soll die zu schaffende elektronische Sicherung in kombinierter Weise einen Schutz gegen Überspannungen aber auch Überströme gewährleisten. Bei Fortfall eines Überspannungsereignisses soll die elektronische Sicherung automatisch in den normalen Betriebszustand übergehen, ohne dass ein händisches Eingreifen notwendig wird.

Die Lösung der Aufgabe der Erfindung erfolgt mit einer elektronischen Sicherung gemäß der Merkmalskombination nach Patentanspruch 1, wobei die Unteransprüche mindestens zweckmäßige Ausgestaltungen und Weiterbildungen umfassen.

Mit der erfindungsgemäßen Sicherung erfolgt eine Bewertung der jeweiligen Ereignisse von einer integrierten Logik unter Anwendung eines Mikrocontrollers. Somit können Lastkurzschlüsse von Überspannungsereignissen getrennt bewertet werden. Kommt es aufgrund eines Überspannungsereignisses zu einem Ansprechen der Sicherung, kann diese nach der Überspannung von dem Mikrocontroller wieder zurückgesetzt werden, so dass es nicht zu einem Ausfall des zu schützenden Systems, respektive der Last kommt.

Mit der erfindungsgemäßen Lösung ist es also nicht mehr notwendig, Überspannungsschutz und Überstromschutz durch zwei Schaltungseinheiten oder Geräte zu realisieren. Eine externe Systembeurteilung nach Auslösen der Sicherung ist nicht mehr notwendig. Ebenso wenig ist es erforderlich, eine angesprochene Sicherung wieder extern freizuschalten.

Mit der erfindungsgemäßen Kombination gelingt es darüber hinaus, die erforderlichen geringen Ansprechspannungen in Gleichspannungsnetzen von zum Beispiel 24 Volt-Systemen zu gewährleisten. Diesbezüglich werden schnellschaltende MOSFETs oder IGBTs eingesetzt.

Mit der erfindungsgemäßen Lösung gelingt es darüber hinaus, einen Schutz der Last vor sogenanntem Power Crossing, das heißt einem Übersprechen eines höheren Spannungspotentials auf die Nennspannung, zu bewirken.

Die elektronische Sicherung besteht aus zwischen Eingangsklemmen und der Last angeordneten Baugruppen. Diese Baugruppen umfassen eine Spannungsüberwachungseinheit, eine Stromüberwachungseinheit sowie Halbleiterschalteinheiten und diesen zugeordnete Steuerungen.

Erfindungsgemäß ist an den Eingangsklemmen zunächst eine Reihenschaltung aus einer TVS-Diode und einem Widerstand angeschlossen. Am Verbindungspunkt zwischen dem Widerstand und der TVS-Diode ist ein erster Anschluss eines Mikrocontrollers angeschlossen.

Der resultierende Spannungsabfall am Widerstand R1 bei überspannungsbedingtem Erreichen der Durchbruchspannung an der TVS-Diode liefert ein Signal hin zum ersten Anschluss des Mikrocontrollers. Dieses Signal dient als Überspannungserkennungssignal.

Ein zweiter Anschluss des Mikrocontrollers steht mit einer ersten Halbleiterschalteinheit in Verbindung.

Die erste Halbleiterschalteinheit ist als Längsschalter in Reihe zur Last liegend vorgesehen, wobei der Mikrocontroller die erste Schalteinheit sperrt wenn das Überspannungserkennungssignal anliegt.

In Reihe zur Last liegt darüber hinaus ein Shunt, ausgebildet als Stromüberwachungseinheit.

Der Spannungsabfall am Shunt wird vom Mikrocontroller über einen dritten Anschluss analysiert. Bei erkanntem, einen Schwellwert übersteigenden Überstrom wird die Last mittels der Halbleiterschalteinheit, bevorzugt ausgebildet als MOSFET, abgeschalten.

Weiterhin befindet sich zwischen den Eingangsklemmen ein MOS-GATE-Thyristor, dessen Steuereingang mit einem vierten Anschluss des Mikrocontrollers in Verbindung steht.

Bei anliegendem Überspannungssignal wird über den vierten Anschluss der MOS-GATE-Thyristor in den Einschaltzustand versetzt.

Die Überstromfunktion der erläuterten Sicherung ist so realisiert, dass dann, wenn an der Last ein Kurzschluss auftritt oder der Stromwert größer ist als ein vorgegebener Schwellwert, der Mikrocontroller dies über den Spannungsabfall am Shunt erkennt und die Last abschaltet. Das Zuschalten der Last kann dann automatisch aber auch über einen externen Reset vorgenommen werden.

Tritt ein Überspannungsereignis auf, steigt die Spannung über der Last bis die Durchbruchspannung der Diode TVS erreicht ist. Der resultierende Spannungsabfall am Widerstand dient dem Mikrocontroller als Überspannungserkennungssignal, welcher dann den MOS-GATE-Thyristor ansteuert, so dass die Überspannung begrenzt wird.

Parallel zum MOS-GATE-Thyristor ist ein Halbleiterschalter, z.B. ausgebildet als IGBT (Isolated Gate Bipolar Transistor) zur Anwendung gekommen. Neben einem solchen IGBT begrenzt auch die erste Halbleiterschalteinheit, ausgebildet als MOSFET die Spannung über der Last nach der Beziehung

$$U_{Last} = U_n + U_G + C_{DS} * du/dt.$$

In einer Weiterbildung der Erfindung ist zwischen dem zweiten Anschluss des Mikrocontrollers und der ersten Halbleiterschalteinheit ein erster Treiber vorgesehen.

Zwischen dem zweiten Anschluss des Mikrocontrollers und dem Steuereingang des MOS-GATE-Thyristors und des IGBT ist ein zweiter Treiber vorgesehen, der bevorzugt galvanisch getrennt realisiert wird.

Steigt die Spannung an der Last über die Gatespannung des ersten Treibers, liegt keine positive Gate-Source-Spannung an der ersten Halbleiterschalteinheit an, was automatisch zum Abschalten dieser führt. Ein weiterer Anstieg der Spannung an der Last ist damit nur noch über eine Spannungsänderung an der Kapazität der als MOSFET ausgebildeten ersten Halbleiterschalteinheit möglich (Kapazität $C_{DS}$). Der Mikrocontroller schaltet den MOSFET grundsätzlich ab, sobald über die Diode TVS eine Überspannung registriert wurde. Erst nach vollständiger Abhandlung eines erkannten Überspannungsereignisses schaltet der Mikrocontroller die Last wieder automatisch zu, wodurch ein unnötiger Anlagenstillstand vermieden wird.

Wie bereits erwähnt, kann erfindungsgemäß die elektronische Sicherung auch zum Schutz vor Power Crossing oder sonstigen dauerhaften oder temporären Spannungsüberhöhungen dienen. In diesem Fall wird über die TVS-Diode erkannt, ob eine Überspannung vorliegt. Diese klingt jedoch nicht wie bei transienten Ereignissen innerhalb einer Zeit von 100 μs bis 2 ms ab. Beim Abschalten des IGBTs nach dieser Zeit liegt deshalb erneut ein Steuersignal über die TVS-Diode am Mikrocontroller an. Kann der IGBT die Überspannung auch nach mehreren Abschaltversuchen, zum Beispiel nach einer Zeit von 5 - 10 ms nicht abhandeln, wird auf eine temporäre Überspannung geschlossen. Ist eine solche erkannt, schaltet der Mikrocontroller den IGBT dauerhaft ein und löst damit ein vorgelagertes passives Sicherungselement $F_1$ aus.

Ein automatisches Wiedereinschalten der Sicherung erfolgt nach Analyse und Feststellung eines Endes des Überspannungsereignisses. Dies wird beispielsweise dadurch realisiert, dass zyklisch für eine kurze Zeit der IGBT und der MOS-GATE-Thyristor ausgeschalten werden und dabei die Reaktion des Spannungsverlaufes über den Widerstand der Reihenschaltung mit der TVS-Diode verfolgt wird.

In Weiterbildung der Erfindung kann zwischen den Eingangsklemmen, bevorzugt antiparallel zum MOS-GATE-Thyristor, noch eine Sperrdiode vorgesehen sein, welche negative Überspannungsereignisse ableitet. Positive Überspannungsereignisse werden von der Reihenschaltung aus TVS-Diode und Widerstand erfasst.

Zum Treiben großer kapazitiver Lasten ist die Einschaltzeit der ersten Halbleiterschalteinheit durch einen RC-Kreis steuerbar.

In diesem Zusammenhang ist der zwischen dem Gate der ersten Halbleiterschalteinheit und dem zweiten Anschluss des Mikrocontrollers liegende diesbezügliche Widerstand des RC-Kreises einstellbar.

Am Shunt der Stromüberwachungseinheit ist ein Operationsverstärker angeschlossen, welcher mit dem dritten Anschluss des Mikrocontrollers in Verbindung steht.

In Weiterbildung der Erfindung kann zur Begrenzung des Kurzschlussstromes in Reihe zur Last eine Induktanz geschalten werden.

Die Reaktionszeit zum Auslösen der ersten Halbleiterschalteinheit ist durch einer am Operationsverstärker vorgesehenen R-C-Kombination vorgebbar.

Die Erfindung soll nachstehend anhand eines Ausführungsbeispieles sowie unter Zuhilfenahme von Figuren näher erläutert werden.

Hierbei zeigen:

Fig. 1 ein Blockschaltbild zur prinzipiellen Erläuterung der Erfindung; und

Fig. 2 eine erfindungsgemäße Weiterbildung mit Verdeutlichung der Einheiten zum Überspannungsschutz einerseits sowie zum Schutz vor Überströmen andererseits (jeweils gestrichelt dargestellte Rahmen).

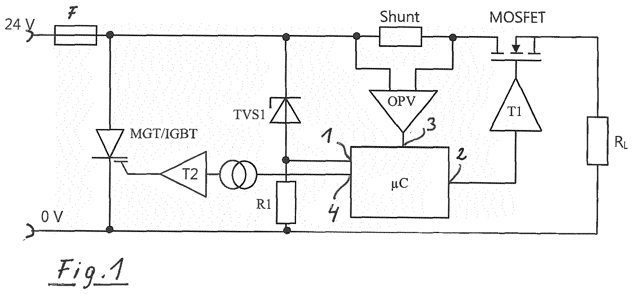

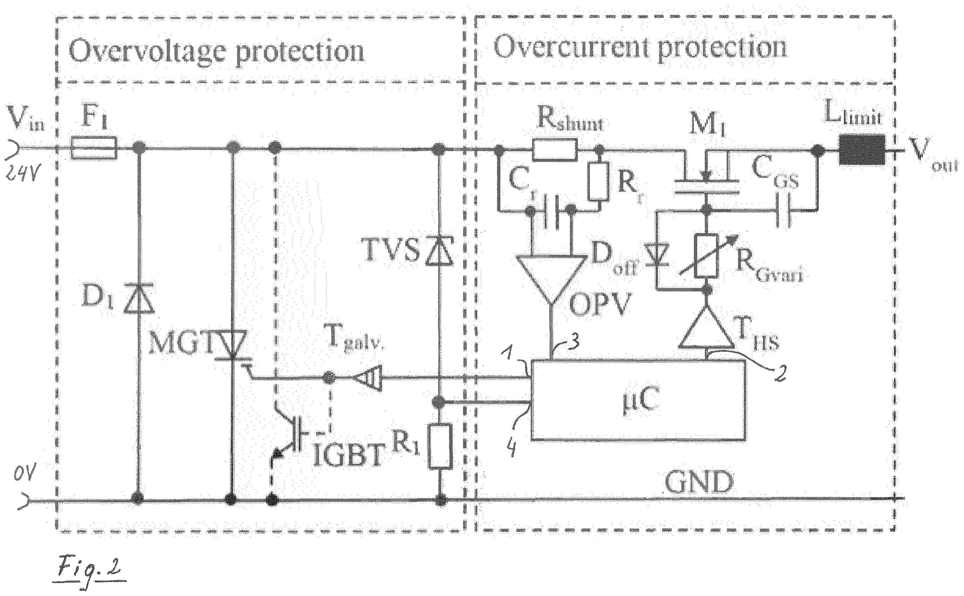

Zwischen den Eingangsklemmen 0 V/24 V eines diesbezüglichen Gleichspannungsnetzes liegt nach einer klassischen Schmelzsicherung F (Fig. 1) bzw. $F_1$ (Fig. 2) die Reihenschaltung aus einer TVS-Diode TVS und einem Widerstand R1.

Der Widerstand R1 steht mit einem ersten Anschluss 1 eines Mikrocontrollers μC in Verbindung.

Bei einem überspannungsbedingten Ereignis, was die Durchbruchspannung an der TVS-Diode TVS überschreitet, ergibt sich ein resultierender Spannungsabfall am Widerstand R1. Dieser Spannungsabfall wird vom Mikrocontroller μC über den Eingang 1 erfasst und als Überspannungserkennungssignal verarbeitet.

Ein zweiter Anschluss 2 des Mikrocontrollers μC steht mit einer ersten Halbleiterschalteinheit MOSFET; M1 in Verbindung, wobei die erste Halbleiterschalteinheit MOSFET; M1 als Längsschalter in Reihe zur Last RL liegt.

Der Mikrocontroller μC sperrt die erste Halbleiterschalteinheit MOSFET; M1 dann, wenn das Überspannungserkennungssignal wie vorstehend erläutert, anliegt.

In Reihe zur Last $R_L$ ist ein Shunt $R_{shunt}$ als Stromüberwachungseinheit ausgebildet, wobei der Spannungsabfall am Shunt vom Mikrocontroller μC über einen dritten Anschluss 3 analysiert und bei erkanntem, einen Schwellwert übersteigenden Überstrom die Last RL mittels der ersten Halbleiterschalteinheit MOSFET; M1 abgeschalten wird.

Weiterhin ist zwischen den Eingangsklemmen 0 V/24 V ein MOS-GATE-

Thyristor MGT und ein IGBT (wie Fig. 2) angeschlossen, deren Steuereingang mit einem vierten Anschluss 4 des Mikrocontrollers μC in Verbindung steht, derart, dass bei anliegendem Überspannungserkennungssignal der MOS-GATE-Thyristor MGT und der IGBT (in der Fig. 2 gestrichelt dargestellt) in den Einschaltzustand versetzbar sind.

Zwischen dem zweiten Anschluss 2 des Mikrocontrollers μC und der ersten Halbleiterschalteinheit MOSFET; M1 ist ein erster Treiber T1 (Fig. 1) bzw. THS (Fig. 2) vorgesehen.

Zwischen dem vierten Anschluss 4 des Mikrocontrollers μC und dem Steuereingang des MGT und des IGBT ist ein zweiter Treiber T2 vorgesehen, der gemäß Fig. 2 bevorzugt als galvanisch getrennter Treiber $T_{galv}$ realisiert wird.

Gemäß der Ausführungsform nach Fig. 2 befindet sich antiparallel zum MOS-GATE-Thyristor MGT und dem IGBT noch eine Sperrdiode D1 zum Ableiten negativer Überspannungsereignisse. Positive Überspannungsereignisse werden von der Reihenschaltung aus TVS-Diode TVS und dem Widerstand R1 erfasst.

In der Ausführungsform der Verwendung eines IGBT als zweite Halbleiterschalteinheit ist der Steuereingang des IGBT am zweiten Treiber T2 bzw. $T_{galv}$ angeschlossen. Der Treiber T2 kann wie in Fig. 1 symbolisch dargestellt, noch mit einer Stromquelle in Verbindung stehen.

Zum Treiben großer kapazitiver Lasten ist die Einschaltzeit der ersten Halbleiterschalteinheit M1 (siehe Fig. 2) durch einen RC-Kreis $R_{Gvari}$; $C_{GS}$ steuerbar.

Der zwischen dem Gate der ersten Halbleiterschalteinheit M1 und dem zweiten Anschluss 2 des Mikrocontrollers liegende Widerstand $R_{Gvari}$ des RC-Kreises ist als einstellbarer Widerstand ausführbar.

Zwei Eingänge eines Operationsverstärkers OPV können entweder unmittelbar mit dem Shunt verbunden werden (siehe Fig. 1) oder aber auch mit einer weiteren R-C-Kombination beschalten werden.

Diesbezüglich ist wie in der Fig. 2 dargestellt am Operationsverstärker OPV zwischen den Eingangsanschlüssen des Operationsverstärkers ein Kondensator $C_r$ und zwischen einem Eingang des Operationsverstärkers und dem Shunt ein Widerstand $R_r$ ausgebildet. Über eine geeignete Wahl der diesbezüglichen R-C-Kombination kann die Reaktionszeit $t_{reaction}$ zum Auslösen der ersten Halbleiterschalteinheit M1 vorgegeben werden.

Mit der erläuterten, gemäß Ausführungsbeispiel realisierten elektronischen Sicherung kann bei einer Nennspannung von 24 V ein Eingangsspannungsbereich von 8 - 48 V überstrichen werden. Als Nominalstrom ist beispielsweise ein Wert von 10 A gesetzt, wobei der maximale Strom einstellbar ist. Die kapazitive Last kann bis in einen Bereich von 15 mF hineinreichen.

Neben der Analyse der am Shunt abfallenden Spannung kann ein Überstromereignis auch durch den Spannungsabfall zwischen Drain und Source des MOSFET detektiert werden. Die Gatespannung für den MOSFET M1 wird generiert durch eine Ladungspumpe und durch einen sogenannten Highside-Treiber $T_{HS}$, wobei eine Spannung von 12 - 15 V oberhalb der Eingangsspannung während des Einschaltens erreichbar ist.

**Patentansprüche**

1. Elektronische Sicherung für eine, an ein Niedervolt-Gleichspannungsnetz anschließbare Last ($R_L$), bestehend aus zwischen Eingangsklemmen (0 V/24 V) und einer Last ($R_L$) angeordneten Baugruppen, diese umfassend eine Spannungsüberwachungseinheit, eine Stromüberwachungseinheit sowie Halbleiterschalteinheiten und diesen zugeordnete Steuerungen sowie einen Mikrocontroller ($\mu$C) und einen an den Eingangsklemmen angeschlossenen Thyristor,
   **dadurch gekennzeichnet, dass**

   an den Eingangsklemmen (0 V/24 V) eine Reihenschaltung aus einer TVS-Diode (TVS) und einem Widerstand (R1) angeschlossen ist, wobei der Widerstand (R1) mit einem ersten Anschluss (1) des Mikrocontrollers ($\mu$C) in Verbindung steht und der resultierende Spannungsabfall am Widerstand (R1) bei überspannungsbedingtem Erreichen der Durchlassspannung an der TVS-Diode (TVS) dem Mikrocontroller ($\mu$C) ein Überspannungserkennungssignal liefert, ein zweiter Anschluss (2) des Mikrocontrollers ($\mu$C) mit einer ersten Halbleiterschalteinheit (M1; MOSFET) in Verbindung steht, wobei die erste Halbleiterschalteinheit (M1; MOSFET) als Längsschalter in Reihe zur Last ($R_L$) liegt, wobei der Mikrocontroller ($\mu$C) die erste Halbleiterschalteinheit (M1; MOSFET) sperrt, wenn das Überspannungserkennungssignal anliegt, in Reihe zur Last ($R_L$) ein Shunt ($R_{shunt}$) als Stromüberwachungseinheit ausgebildet ist, wobei der Spannungsabfall am Shunt ($R_{shunt}$) vom Mikrocontroller ($\mu$C) über einen dritten Anschluss (3) analysiert und bei erkanntem, einen Schwellwert übersteigenden Überstrom die Last ($R_L$) mittels der ersten Halbleiterschalteinheit (M1; MOSFET) abgeschalten wird, weiterhin der zwischen den Eingangsklemmen (0 V/24 V) befindliche Thyristor ein MOS-GATE-Thyristor (MGT;

IGBT) ist, dessen Steuereingang mit einem vierten Anschluss (4) des Mikrocontrollers ($\mu$C) in Verbindung steht, derart, dass bei anliegendem Überspannungserkennungssignal der MOS-GATE-Thyristor (MGT; IGBT) in den Einschaltzustand versetzbar ist, wobei dem MOS-GATE-Thyristor (MGT) eine zweite Halbleiterschalteinheit, ausgebildet als IGBT, parallelgeschalten ist, wobei der Steuereingang des IGBT mit dem vierten Anschluss (4) des Mikrocontrollers ($\mu$C) in Verbindung steht.

2. Elektronische Sicherung nach Anspruch 1,
   **dadurch gekennzeichnet, dass**
   zwischen dem zweiten Anschluss (2) des Mikrocontrollers ($\mu$C) und der ersten Halbleiterschalteinheit (M1; MOSFET) ein erster Treiber (T1; $T_{HS}$) vorgesehen ist.

3. Elektronische Sicherung nach Anspruch 1 oder 2,
   **dadurch gekennzeichnet, dass**
   das zwischen dem vierten Anschluss (4) des Mikrocontrollers ($\mu$C) und dem Steuereingang des MOS-GATE-Thyristors (MGT) ein zweiter, galvanisch getrennter Treiber (T2) vorgesehen ist.

4. Elektronische Sicherung nach einem der vorangegangenen Ansprüche,
   **dadurch gekennzeichnet, dass**
   antiparallel zum MOS-GATE-Thyristor (MGT; IGBT) eine Sperrdiode (D1) zum Ableiten negativer Überspannungsereignisse ausgebildet ist, wobei positive Überspannungsereignisse von der Reihenschaltung aus TVS-Diode (TVS) und Widerstand (R1) erfasst werden.

5. Elektronische Sicherung nach Anspruch 1 und 3,
   **dadurch gekennzeichnet, dass**
   der Steuereingang des IGBT am zweiten Treiber (T2; $T_{galv}$) angeschlossen ist.

**Claims**

1. Electronic fuse for a load ($R_L$) connectable to a low-voltage DC network, consisting of assemblies which are arranged between input terminals (0 V/24 V) and a load ($R_L$) and which comprise a voltage monitoring unit, a current monitoring unit, and semiconductor switching units and control systems assigned thereto, as well as a microcontroller ($\mu$C) and a thyristor connected to the input terminals,
   **characterised in that**

   a series connection of a TVS diode (TVS) and a resistor (R1) is connected to the input terminals (0 V/24 V), the resistor (R1) being connected to a first terminal (1) of the microcontroller (pC), and the resulting voltage drop across the resistor (R1) supplying an overvoltage detection signal to the microcontroller ($\mu$C ) when the forward voltage is reached at the TVS diode (TVS) as a result of overvoltage, a second terminal (2) of the microcontroller ($\mu$C) is connected to a first semiconductor switching unit (M1; MOSFET), the first semiconductor switching unit (M1; MOSFET) being in series with the load ($R_L$) as a longitudinal switch, the microcontroller ($\mu$C) blocking the first semiconductor switching unit (M1; MOSFET) when the overvoltage detection signal is present,
a shunt ($R_{shunt}$) is formed in series with the load ($R_L$) as a current monitoring unit, the voltage drop across the shunt ($R_{shunt}$) being analysed by the mictrocontroller ($\mu$C) via a third terminal (3) and the load ($R_L$) being switched off by means of the first semiconductor switching unit (M1; MOSFET) if an overcurrent exceeding a threshold is detected, the thyristor located between the input terminals (0 V/24 V) is further a MOS gate thyristor (MGT; IGBT), the control input of which is connected to a fourth terminal (4) of the microcontroller ($\mu$C) in such a way that when the overvoltage detection signal is present the MOS gate thyristor (MGT; IGBT) can be shifted into the on state, a second semiconductor unit, formed as an IGBT, being connected in parallel with the MOS gate thyristor (MGT), the control input of the IGBT being connected to the fourth terminal (4) of the microcontroller ($\mu$C).

2. Electronic fuse according to claim 1,
**characterised in that**
a first driver (T1; $T_{HS}$) is provided between the second terminal (2) of the microcontroller ($\mu$C) and the first semiconductor switching unit (M1; MOSFET).

3. Electronic fuse according to either claim 1 or claim 2,
**characterised in that**
a second, galvanically isolated driver (T2) is provided between the fourth terminal (4) of the microcontroller ($\mu$C) and the control input of the MOS gate thyristor (MGT).

4. Electronic fuse according to any of the preceding claims,
**characterised in that**
a blocking diode (D1) for diverting negative overvoltage events is formed in antiparallel with the MOS gate thyristor (MGT; IGBT), positive overvoltage events being captured by the series connection of the TVS diode (TVS) and the resistor (R1).

5. Electronic fuse according to claims 1 and 3,
**characterised in that**
the control input of the IGBT is connected to the second driver (T2; $T_{galv}$) .

**Revendications**

1. Fusible électronique pour une charge ($R_L$) pouvant être connectée à un réseau à courant continu basse tension, composé d'ensembles disposés entre des bornes d'entrée (0 V/24 V) et une charge ($R_L$), lesquels comprennent une unité de surveillance de tension, une unité de surveillance de courant ainsi que des unités de commutation à semi-conducteur et des commandes associées à celles-ci ainsi qu'un microcontrôleur ($\mu$C) et un thyristor connecté aux bornes d'entrée,
**caractérisé en ce**

qu'un circuit série composé d'une diode TVS (TVS) et d'une résistance (R1) est connecté aux bornes d'entrée (0 V/24 V), dans lequel la résistance (R1) est reliée à une première connexion (1) du microcontrôleur ($\mu$C) et la chute de tension résultante aux bornes de la résistance (R1) fournit un signal de détection de surtension au microcontrôleur ($\mu$C) lorsque la tension directe aux bornes de la diode TVS (TVS) est atteinte en raison d'une surtension,
une deuxième connexion (2) du microcontrôleur ($\mu$C) est reliée à une première unité de commutation à semi-conducteur (M1 ; MOSFET), dans lequel la première unité de commutation à semi-conducteur (M1 ; MOSFET) est montée en série avec la charge ($R_L$) en tant que commutateur série, dans lequel le microcontrôleur ($\mu$C) bloque la première unité de commutation à semi-conducteur (M1 ; MOSFET) lorsque le signal de détection de surtension est présent, un shunt ($R_{shunt}$) est formé en série avec la charge ($R_L$) en tant qu'unité de surveillance de courant, dans lequel la chute de tension sur le shunt ($R_{shunt}$) est analysée par le microcontrôleur ($\mu$C) via une troisième connexion (3) et, si une surintensité dépassant une valeur seuil est détectée, la charge ($R_L$) est déconnectée au moyen de la première unité de commutation à semi-conducteur (M1 ; MOSFET), en outre le thyristor situé entre les bornes d'entrée (0 V/24 V) est un thyristor MOS-GATE (MGT ; IGBT) dont l'entrée de commande est reliée à une quatrième connexion (4) du microcontrôleur ($\mu$C) de telle sorte que, lorsqu'un signal de détection de surtension est présent, le thyristor MOS-GATE (MGT ; IGBT) peut être mis dans l'état activé, dans lequel une deuxième unité de commutation à semi-conducteur, réalisée sous la forme d'un IGBT, est connectée en parallèle avec le thyristor MOS-GATE (MGT), l'entrée de commande de l'IGBT étant reliée à la quatrième connexion (4) du microcon-

trôleur ($\mu$C).

2. Fusible électronique selon la revendication 1, **caractérisé en ce qu'**un premier circuit d'attaque (T1 ; THS) est prévu entre la deuxième connexion (2) du microcontrôleur ($\mu$C) et la première unité de commutation à semi-conducteur (M1 ; MOSFET).

3. Fusible électronique selon la revendication 1 ou 2, **caractérisé en ce qu'**un deuxième circuit d'attaque (T2) isolé électriquement est prévu entre la quatrième connexion (4) du microcontrôleur ($\mu$C) et l'entrée de commande du thyristor MOS-GATE (MGT).

4. Fusible électronique selon l'une des revendications précédentes, **caractérisé en ce qu'**une diode de blocage (D1) est formée antiparallèlement au thyristor MOS-GATE (MGT ; IGBT) pour dériver les événements de surtension négative, les événements de surtension positive étant détectés par la connexion en série de la diode TVS (TVS) et de la résistance (R1).

5. Fusible électronique selon les revendications 1 et 3, **caractérisé en ce que** l'entrée de commande de l'IGBT est connectée au deuxième circuit d'attaque (T2 ; $T_{galv}$) .

EP 3 583 670 B1

**Fig.1**

Fig.2

EP 3 583 670 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5875087 A
- DE 102015105426 A1
- US 9401593 B2
- US 5440441 A
- DE 102011016140
- EP 3104483 A1
- US 2016149403 A
- EP 0686953 A1
- DE 10358694 A1
- WO 2017021013 A1